# EUROPEAN PATENT APPLICATION

(11) **EP 4 325 189 A1**
(43) Date of publication of application: **21.02.2024**
(21) Application number: 22191175.3
(22) Date of filing: 19.08.2022
(51) Int. Cl.: G01L 1/16, G01L 9/00, G01L 23/10, G01G 3/13, G01H 11/08, G01P 15/09

(54) **PIEZOELECTRIC SENSOR DEVICE**

(71) Applicant: Meggitt SA, 1701 Fribourg (CH)
(72) Inventor: Egger, Gérald, 1720 Corminboeuf (CH); Giossi, Samuel, 1700 Fribourg (CH); Jeunet, Cyril, 1562 Corcelles-près-Payerne (CH)
(74) Representative: AMMANN PATENTANWÄLTE AG

(57) **Abstract**

A piezoelectric sensor device (11) comprising a piezoelectric element (1) and at least one metallic body (14, 16), with an insulating body (2) arranged between each metallic body (14, 16) and the piezoelectric element (1). The insulating body (2) substantially consists of a crystalline material or ceramics. At least one surface of the insulating body (2) in contact with the metallic body (14, 16) is covered by a metallic layer (3) in order to suppress noise signals due to a stick-slip effect and differing thermal expansion coefficients

## Description

The present invention relates to a piezoelectric sensor device according to the preamble of claim 1.

Sensor devices comprising a piezoelectric element are well known in the art. They serve to determine forces, f. i. pressure and forces exerted on constructional elements. In combination with seismic masses, vibrations are detected, f. i. of engines. Other effects which may be measured are speed and load. Another application is to measure mechanical effects in general as far as they can be transformed into forces exerted on the piezoelectric sensor.

A basic design principle is that the piezoelectric element is arranged between electrical insulators, so that the electrical charge is not dispersed yet creates a voltage at the surface of the piezoelectric element which can be measured, and this arrangement is in contact with metallic parts. Due to the different materials, however, the piezoelectric element and the insulators have differing CTEs (coefficient of thermal expansion) values and undergo differing thermal expansion when the operating temperature changes. As a rule, crystals and ceramics are characterized by a lower CTE whereas most metals have a more elevated CTE. In fact, it has been observed that under some circumstances, thermal transients may be a source of a parasitic signal that is added to sensor output. Presumably, the surfaces of the crystallinic parts (insulators; piezoelectric element) and the metallic parts where these components are contacting each other, shift relatively to or slide on each other. This sliding may create the parasitic signal which may prevent making an accurate monitoring and may generate faulty alarms where a piezoelectric sensor device is deployed to watch the operation and to detect irregular operating conditions of a machine, generally depending on the frequency or frequency range of interest.

More specifically, sliding occurring between components may have either a continuous or a stick-slip behaviour which generates a parasitic signal.

The occurrence of stick-slip type sliding is related to the level of CTE mismatch, contact area dimension and friction coefficients at the interface. Stick-slip sliding is more likely to happen when at least one of the components in contact is made of a material with negligible ductility, for example a ceramic or a single crystal.

The stick-slip sliding may also be influenced by the manufacturing process of components with higher inherent ductility, for example metallic alloys. Appropriate manufacturing process may decrease the risk of stick-slip type sliding at an interface. However slight variations in properties between raw material batches as well as of manufacturing process parameters may prevent to attain perfect removal of stick-slip sliding in a device design.

An obvious remedy is to select material of as close as possible similar thermal expansion coefficient. Another approach, even applied in combination, would be to select materials of low thermal expansion coefficient. One approach disclosed by EP3665459A1 is to insert a transition element between force introduction element and piezoelectric element which is able to compensate for the thermal dilation of the surfaces of piezoelectric element and the insulator in deforming itself. However, this approach complicates the design and is of limited effect as the transition element has to be carefully designed in order not to impede the measurement. According to this prior art stresses are reduced as the transition element absorbs the dimensional changes of the adjacent surfaces.

Accordingly, it is an object of the present invention to propose a piezoelectric sensor device in which noise signals due to thermal transients are reduced.

Preferably, it is an object to suppress such parasitic signals and to providing reliable measurement in any frequency or frequency range and temperature conditions

Such a device is defined by claim 1. The further claims define preferred embodiments and methods of producing the device.

Throughout the description and the claims, percentages are percentages by weight unless otherwise specified. Used abbreviations are listed in the Glossary appended to the description.

Generally, if has been found that the parasitic signal originating from differing thermal expansion is caused by aleatoric microscopic slide movements of the contacting surfaces of the bodies in contact with each other, in particular of the contacting surfaces or interfaces of a metallic body and an insulating body, wherein the insulating body essentially consists of crystalline material or ceramics. Due to forces and effects inhibiting a relative movement of the surfaces (bodies are pressed against each other; surface roughness, interatomic attractive forces like van-der-Waals force, dipolar force etc.) the surfaces stick to each other and during a temperature change, mechanical tension increases. Once the tension reaches a certain level, however, the tension get larger than the inhibiting forces, and the surfaces rapidly move with respect to each other. It is assumed that once the movement begins the inhibiting forces are much smaller so that the movement stops only once as much smaller mechanical tension is attained. Of course, this phenomenon is in the microscopic domain and occurs locally in different location of the interface. As each such event creates a pulse signal (or a spike), the result is a random noise signal.

In order to reduce this effect and in particular the noise signal resulting therefrom it is proposed to arrange a layer in the interface which reduces the stick effect so that the surfaces are able to smoothly move with respect to each other in order to balance different thermal expansion.

It has been found that such a layer may consist of a metal. Preferably, it comprises a precious metal. The preferred method of providing the layer is to cover at least one of the surfaces with such a metallic layer, preferably the surface of the insulator.

The layer can be applied most conveniently by screen printing. However, other methods appear feasible, f. i. applying a first layer by a deposition technique like CVD (chemical vapour deposition) or PVD (physical vapour deposition) and related methods. If the layer is not sufficiently thick, it may be grown to a required thickness by e.g. an electrochemical process like galvanization.

Preferred metal constituents are silver, gold, platinum, and palladium, or nickel. Silver has been found to be acceptable for sensors with an upper operating temperature of about 600 K, or more precisely 570 K. Above that temperature, gold is preferred.

The invention will be further explained by preferred execution examples with reference to the Figures. They show:
- Fig. 1: Schematic construction of a piezoelectric sensor device, compression mode;
- Fig. 2: Schematic construction of a piezoelectric sensor device, shear mode; and
- Fig. 3: Schematic construction of a piezoelectric sensor device, transverse mode;

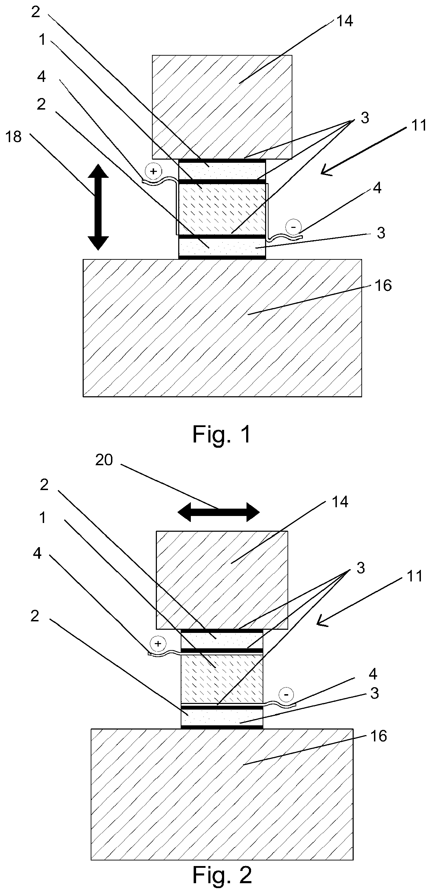

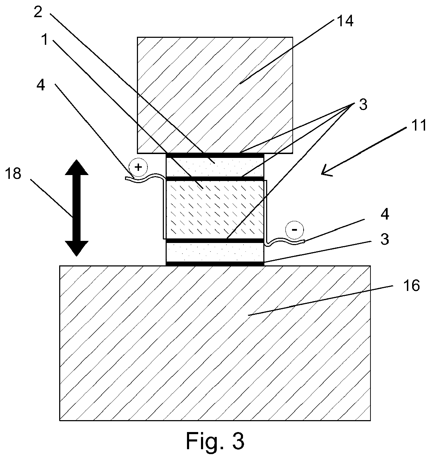

Fig. 1 shows a piezoelectric sensor device 11, here a so-called compression mode sensor. Sensors based on piezoelectric materials are usually composed of one or more piezoelectric parts 1 electrically insulated from the surrounding, often metallic, components by insulators 2 made of ceramic or a single crystal. Opposite to the piezoelectric element 1, carrier bodies 14 and 16 which transmit load and/or force are arranged in contact with the insulators 2. In a compression mode sensor device (Fig. 1), forces act in direction of arrow 18 and tend to compress the piezoelectric parts 1. In shear mode (Fig. 2), the forces act laterally (arrow 20) and tend to shear the piezoelectric parts 1. A third mode is the transverse mode sensor device (Fig. 3) where the charges are generated in a direction transverse to the direction of force 18 acting on the piezoelectric parts. In the transverse mode sensor device shown, the electrodes 4 are attached laterally on the piezoelectric element, whereas in the preceding variants, the electrodes are attached to the surfaces adjacent to the insulators 2.

The forces are impacted by the upper carrier body 14 whereas the lower carrier body 16 constitutes the basis as a reference. F. i., body 14 may be a seismic mass only held by its mounting on the piezoelectric parts 1, whereas the lower carrier body 16 is part of the mounting arrangement by which the sensor is attached on an object. Other forces measured are speed, pressure, and load. Measured objects are e.g. gas turbines; engines; oil and gas monitoring equipment, and related equipment.

The basics of construction of such a piezoelectric sensor device is known in the art. Therefore, details of their design known in the art like electric connections of the piezoelectric element 1 and internal design, e.g. the composition of the piezoelectric element as a pile of piezoelectric parts, possibly each one with electrical connections, are omitted.

As the sensor operates at different ambient temperatures, the components undergo thermal expansion and contraction. Due to the stick-slip- effect as explained above, a corresponding parasitic signal is generated.

Practically, different expansion movements result in tension on the interface resulting in signal noise. Particularly in security sensitive domains, like aeronautics or power generation, such effects are highly disadvantageous.

The solution to solve the problem of parasitic signal coming from stick-slip sliding consists in the deposition of a metallic layer 3 (thickness emphasized for illustration purposes) on the ceramic or single crystal insulator 2 used to electrically insulate the piezoelectric element from the surrounding metallic components.

The addition of a metallic layer 3 on the ceramic or single crystal insulator 2 surface changes the interface from ceramic-metal or crystal-metal to metal-metal. The resulting interface between the insulator component 2 and the surrounding metallic components (upper and lower carrier bodies 14, 16) has a different friction coefficient and the sliding is continuous without stick-slip effect. Better results are obtained with metal layer 3 on both sides of the insulator, one side being in contact with a metallic mechanical part and the other side being in contact with a metallic foil used to collect the electrical signal from the piezoelectric element.

The metal layer is deposited by screen printing with a thickness preferably between 3 to 12 microns (micrometer), maximally 1 to 20 microns. A commercially available screen printing paint with suitable stability and oxidation resistance at the application temperature is applied. For applications up to 650°C (923 K), and in the extreme up to 1100 K (827 °C), the alloy used for the metal layer contains at least 80 % gold. For applications up to 300 °C (573 K), the alloy contains at least 80 % Silver.

The used metal containing inks are of the type requiring a firing after drying at more elevated temperatures above 500 °C (773 K). Preferred are firing temperatures in the ranges 650 °C (923 K) to 900 °C (1173 K). The entire firing cycle may last 45 minutes to 90 minutes, or about 60 minutes. The peak temperatures mentioned above are held for some time within the firing cycle, roughly in the range 5 minutes to 20 minutes, or preferably 7 minutes to 15 minutes, and often for about 10 minutes.

It has been found that even unavoidable fluctuation of the properties of the raw material do not have a significant, and mostly not even sensible, impact on the suppression of the noise signal. Furthermore, applying the metal layers can be easily implemented in existing sensors without modification of parameters, which is a big advantage in highly regulated domains like the aviation industry. Specifically, the uncoated ceramic or single crystal insulator is replaced by the same insulator 2 yet provided with a metallic layer 3.

All other components of the sensor remain the same and the sensor can be manufactured using the same tooling and same processes.

Screen printing is the preferred method of applying the metallic surface layer of the intended thickness, as it is a well-known technique for this purpose, in particular for metallic layer on crystalline surfaces. According to the report David A. Roberson et al., Microstructural and Process Characterization of Conductive Traces Printed from Ag Particulate Inks, Materials 2011, 4, 963-979 (doi: 10.3390/ma4060963), the surface layers obtained show a significantly smoother surface if inks are used which are fired at higher temperatures. In the publication, an ink was used which had been fired at 850 °C for 10 minutes. Another advantage is the acceptable or even highly satisfying adherence of the obtained layers to the substrate. In comparison experiments with layers comprising aluminium, the layers stuck insufficiently to the surface of the crystalline or ceramic substrate.

In addition to screen printing, metallic layers may also be deposited by PVD, CVD, galvanic deposition or a combination of processes.

Depending on the deposition method, the typical metallic layer thickness is between 1 and 20 microns, more preferably 3 to 12 microns. The metals used should have a good oxidation resistance and should be stable at the sensor working temperature, i.e. not liquefy, corrode or undergo any other deterioration. Metals used are typically Nickel, Silver, Gold, Platinum, and Palladium, either pure or combined in alloys or multilayer deposits. Silver based layers (silver content at least 80 %) is preferably used for applications up to 300°C, Gold based (gold content at least 80 %) is preferred for applications up to 650°C.

The addition of a metallic layer on the ceramic insulator surface changes the interface from a ceramic-metal contact to a metal-metal contact. The resulting interface between the ceramic insulator component and the adjacent metallic component has a different friction coefficient and the sliding is continuous without stick-slip effect.

From the foregoing description the one skilled in the art is able to conceive variants and extensions without leaving the scope of the invention which is defined by the claims. Conceivable is, for example:
- The piezoelectric sensor devices are designed for applications within the temperature range from -269 °C to 1000 °C (4K to 1273 k), more preferably -250 °C to 850 °C (23 K to 1123K) and even more preferably -70 °C to 700 °C (203 K to 973 K).
- Often used materials for the insulating bodies are alumina (aluminum oxide), sapphire, AIN (aluminum nitride).
- More generally, the surface covered by the metallic layer may be constituted by an inorganic material.
- The metallic layer consists of another precious metal or an alloy comprising one or more precious metal, the precious metal being selected from gold, silver, platinum, palladium, and a platinum metal other than platinum or palladium.
- The metallic layers in contact with the piezoelectric element serve as electric contacts.
- The piezoelectric element is a single, integral component, or a stack of two or more of such components as generally known in the art. In case of a stack of such components, electrodes and optionally isolating layers may be interspersed in order to attain a serial or parallel arrangement in order to improve the useful signal. Such arrangements are known as well *per se* in the art.

### Glossary

- CVD: Chemical vapour deposition
- CTE: Coefficient of thermal expansion
- PVD: Physical vapour deposition

## Claims

1. Piezoelectric sensor device (11) sensible to applied forces comprising a piezoelectric element (1) and at least one electrically insulating body (2) attached to a surface of the piezoelectric element so that the body is able to impart a force on the piezoelectric element, the piezoelectric element (1) and the at least one electrically insulating body (2) constituting a sensor element arrangement, at least one of the piezoelectric element and the electrically insulating body being further in mechanical contact at first adjacent surfaces with a second body (14, 16), wherein at least the first adjacent surface of the second body in contact with the at least one of the piezoelectric element and the insulating body is metallic, **characterized in that** the first adjacent surface of the at least one of the piezoelectric element and the electrically insulating body is a metallic surface (3) substantially consisting of a metallic material in order to reduce a noise signal, in particular a noise signal originating from differing thermal expansion of the at least one of the piezoelectric element and the electrically insulating body and the adjacent second body.

2. Piezoelectric sensor device (11) according to claim 1, **characterized in that** all first adjacent surfaces of pairs of the first adjacent surfaces adjacent to each other are metallic surfaces (3).

3. Piezoelectric sensor device (11) according to one of claims 1 to 2, **characterized in that** at least one of the insulating bodies (2) consists of one of an insulating inorganic material, an insulating crystalline material, an insulating ceramics, alumina, sapphire, AIN, with crystalline material including piezoelectric crystalline material of increased electrical resistance with respect to the electrical resistance of the piezoelectric element(1).

4. Piezoelectric sensor device (11) according to one of claims 1 to 3, **characterized in that** the metallic surface (3) consists of a metal or an alloy.

5. Piezoelectric sensor device (11) according to one of claims 1 to 4, **characterized in that** the metallic surface (3) is a layer of a precious metal or of an alloy comprising at least 50 wt.-% of a precious metal, the precious metal being preferably nickel, silver, gold, platinum, or palladium.

6. Piezoelectric sensor device (11) according to one of claims 1 to 5, **characterized in that** the metallic material has at least 80 wt-% total content of nickel, silver, gold, and platinum, preferably substantially consists of pure silver or gold or platinum.

7. Piezoelectric sensor device (11) according to one of claims 1 to 6, **characterized in that** the piezoelectric element (1) is arranged between at least two electrically insulating bodies (2) constituting the sensor element arrangement, and the sensor element arrangement is arranged between two second bodies (14, 16).

8. Piezoelectric sensor device (11) according to one of claims 1 to 7, **characterized in that** the metallic layer has a thickness from 1 to 20 microns, preferably 3 to 12 microns.

9. Piezoelectric sensor device (11) according to one of claims 1 to 8, **characterized in that** it is designed for an application selected from:
a) use in a temperature range with an upper temperature limit in the range up to 923 K, more preferably up to 1100 K, even more preferably additional above 573 K, wherein the metallic surface substantially consist of gold or an alloy comprising at least 80 wt.-% gold;
b) use in a temperature range up to 573 K, wherein the metallic surface substantially consists of silver or an alloy comprising at least 80 wt.-% silver.

10. Piezoelectric sensor device (11) according to one of claims 1 to 9, **characterized in that** the piezoelectric element is arranged in one of compression mode, shear mode, or transverse mode.

11. Method of manufacturing of the piezoelectric sensor device (11) according to one of claims 1 to 10, **characterized in that** the metallic surface (3) is applied by screen printing.

12. Method of manufacturing of the piezoelectric sensor device (11) according to claim 11, **characterized in that** the metallic surfaces (3) applied by screen printing is fired at a temperature at or above 773 K, preferably at or above 923 K, more preferably at or above 973 K.

13. Method of manufacturing the piezoelectric sensor device (11) according to claim 12, **characterized in that** the metallic surface (3) is fired at a temperature not higher than 1273 K, preferably not more than 1173 K.

14. Method of manufacturing the piezoelectric sensor device (11) according to one of claims 1 to 10, **characterized in that** the metallic surface (3) is applied by first applying a layer by CVD or PVD, and subsequently depositing the metallic material up to the intended thickness, preferably by galvanisation.
